# EUROPEAN PATENT SPECIFICATION

(11) **EP 2 197 032 B1**
(45) Date of publication and mention of the grant of the patent: **05.11.2014**
(21) Application number: 07807139.6
(22) Date of filing: 12.09.2007
(51) Int. Cl.: H01L 27/146

(54) **SOLID-STATE IMAGING DEVICE**
FESTKÖRPER-ABBILDUNGSVORRICHTUNG
CAPTEUR D'IMAGE A L'ETAT SOLIDE

(43) Date of publication of application: 16.06.2010
(60) Divisional application: 12001395.8
(73) Proprietor: Unisantis Electronics Singapore Pte. Ltd., Singapore 179098 (SG)
(72) Inventor: MASUOKA, Fujio, Tokyo 102-0072 (JP); NAKAMURA, Hiroki, Tokyo 102-0072 (JP)
(74) Representative: Röthinger, Rainer
(86) International application number: PCT/JP2007/067732
(87) International publication number: WO 2009/034623

(56) References cited:
- WO-A1-01/22494
- JP-A- 01 175 775
- JP-A- 02 089 368
- JP-A- 2001 339 057
- JP-A- 2002 246 580
- JP-A- 2004 259 733
- US-A1- 2003 002 093
- US-A1- 2006 043 520
- JUN-ICHI NAKAMURA: "NONDESTRUCTIVE READOUT MODE STATIC INDUCTION TRANSISTOR (SIT) PHOTO SENSORS", IEEE TRANSACTIONS ON ELECTRON DEVICES, IEEE SERVICE CENTER, PISACATAWAY, NJ, US, vol. 40, no. 2, 1 February 1993 (1993-02-01), pages 334-341, XP000335340, ISSN: 0018-9383, DOI: DOI:10.1109/16.182510

## Description

### TECHNICAL FIELD

The present invention relates to a solid-state imaging device.

### BACKGROUND ART

There has been proposed an amplification type solid-state imaging device configured to have an amplification function on a pixel-by-pixel basis and perform a readout operation using a scanning circuit, i.e., a CMOS image sensor. The CMOS image sensor has a photoelectric conversion section, an amplification section, a pixel selection section and a reset section which are formed in one pixel, using three MOS transistors in addition to a photodiode making up the photoelectric conversion section (see, for example, the Patent Publication 1). The CMOS image sensor is operable to store electric charges generated by the photoelectric conversion section made up of a photodiode, and, after amplifying the stored electric charges through the amplification section, read out the amplified electric charges using the pixel selection section.

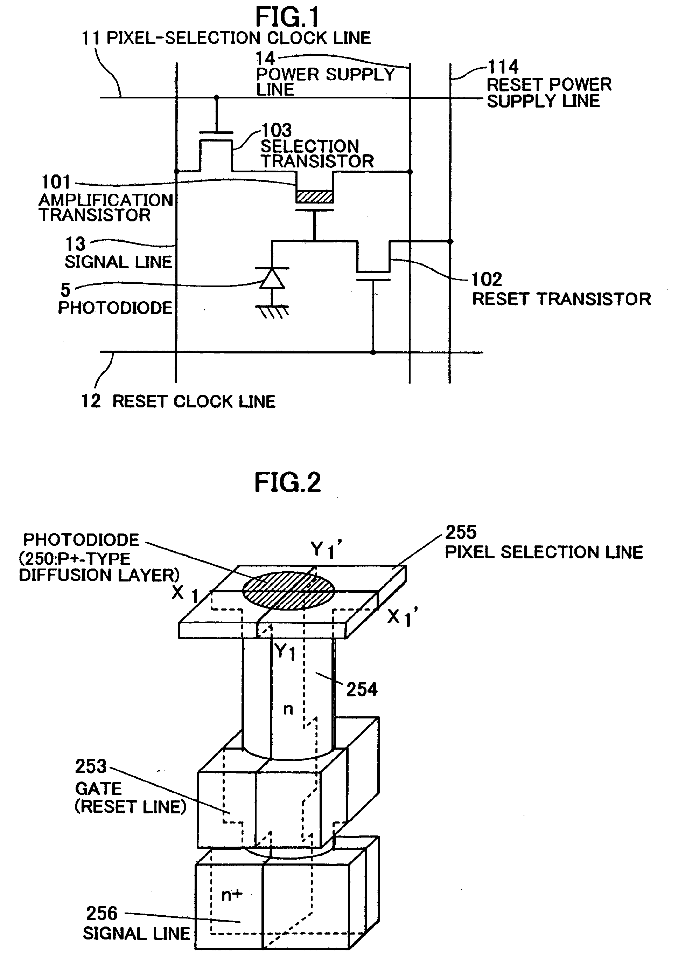

FIG. 1 shows a unit pixel of a conventional CMOS image sensor. In FIG. 1, the reference numeral 5 indicates a photoelectric-conversion photodiode. The reference numerals 101, 102 and 103 indicate an amplification transistor, a reset transistor and a selection transistor, respectively. The reference numerals 13, 11, 12 14 and 114 indicate a signal line, a pixel-selection clock line, a reset clock line, a power supply line, and a reset power supply line, respectively. The unit pixel of the conventional CMOS image sensor has the photodiode and the three MOS transistors in a plane. This means that it is difficult to achieve a high degree of pixel integration.

[Patent Document 1] JP 2000-244818A

US 2006/043520 A1 discloses an imager pixel cell with a photosensitive JFET structure having a channel region located above a buried charge accumulation region. The channel region has a charge flow characteristic that changes depending on the level of accumulated charge in the accumulation region. During an integration period, incident light causes electrons to be accumulated inside the buried accumulation region. The charge flow characteristic of the channel region changes in response to a field created by the charges accumulated in the accumulation region. With respect to a conventional 4T pixel cell, such structure allows a non-destructive readout of pixel cell and an increased fill factor.

WO 01/22494 A1 discloses vertical pixel cells which, due to a mesa layer structure, allow for an increased pixel density in CMOS cameras. The aforementioned document discloses in particular a vertical pixel cell element provided with a stacked p-i-n photodiode and a vertical transistor (i.e. a transistor comprising vertically arranged canal region). The p-i-n photodiode and the vertical transistor are arranged in series between a bit line and a contact line. The vertical transistor transfers charges accumulated in the photodiode to the bit line disposed underneath the vertical pixel structure whereas the contact line is disposed on top of the mesa structure.

### DISCLOSURE OF THE INVENTION

### [PROBLEM TO BE SOLVED BY THE INVENTION]

It is therefore an object of the present invention to provide a CMOS image sensor with a high degree of pixel integration.

### [MEANS FOR SOLVING THE PROBLEM]

This object is addressed by a solid state-imaging device according to claim 1 and a method according to claim 5. The dependent claims define advantageous aspects of the device and method.

In accordance with a first aspect, there is provided a solid-state imaging device which comprises: a signal line formed on a Si substrate; an island-shaped semiconductor formed on the signal line, wherein the island-shaped semiconductor includes: a first semiconductor layer formed as a bottom portion of the island-shaped semiconductor and connected to the signal line; a second semiconductor layer formed above and adjacent to the first semiconductor layer; a gate connected to the second semiconductor layer through an insulating film; a charge storage section comprised of a third semiconductor layer connected to the second semiconductor layer and adapted, in response to receiving light, to undergo a change in amount of electric charges therein; and a fourth semiconductor layer formed above and adjacent to the second and third semiconductor layers; and a pixel selection line connected to the fourth semiconductor layer formed as a top portion of the island-shaped semiconductor; wherein the second semiconductor layer has a first portion and a second portion, wherein the gate is formed to surround an outer periphery of the first portion of the second semiconductor layer through the insulating film, and the third semiconductor layer is formed to surround an outer periphery of the second portion of the second semiconductor layer.

The signal line is an n+-type diffusion layer; the first semiconductor layer is an n+-type diffusion layer; the second semiconductor layer is a p-type impurity-doped region; the third semiconductor layer is an n-type diffusion layer; and the fourth semiconductor layer is a p+-type diffusion layer.

A combination of the p+-type diffusion layer and the n-type diffusion layer functions as a photoelectric-conversion photodiode; a combination of the p+-type diffusion layer, the n-type diffusion layer and the p-type impurity-doped region functions as an amplification transistor; and a combination of the n+-type diffusion layer of the first semiconductor layer, the p-type impurity-doped region, the n-type diffusion layer and the gate functions as a reset transistor.

In another preferred embodiment of the present invention, the first portion of the second semiconductor layer is formed in a cross-sectionally-circular pillar shape.

The second portion of the second semiconductor layer is formed in a cross-sectionally-circular pillar shape.

In accordance with a second aspect of the present invention, there is provided a solid-state imaging device array comprising a plurality of the above solid-state imaging devices which are arranged on the substrate in an n-row by m-column array, wherein each of n and m is an integer of 1 or more.

In accordance with a third aspect, there is provided a method of driving the above solid-state imaging device, which comprises the step of applying a first drive voltage to the pixel selection line, applying a second drive voltage to the signal line and applying a third drive voltage to the gate, to reset the charge storage section.

The method may further comprise the step of receiving light, while applying the first drive voltage to respective ones of the pixel selection line, the gate and the signal line, to change an amount of electric charges stored in the charge storage section. The method may further comprise the step of applying the second drive voltage to the pixel selection line, applying the first drive voltage to the gate and applying the first drive voltage to the signal line, to produce a flow of readout current while amplifying the electric charges stored in the charge storage section and, so as to perform a readout operation.

Preferably, in the method of the present invention, the first drive voltage, the second drive voltage and the third drive voltage are set at zero V, 1 V, and 1.5 V, respectively.

### [EFFECT of THE INVENTION]

As stated above, the present invention provides a solid-state imaging device which comprises: a signal line formed on a Si substrate, the signal line being an n+-type diffusion layer; an island-shaped semiconductor formed on the signal line, wherein the island-shaped semiconductor includes: a first semiconductor layer formed as a bottom portion of the island-shaped semiconductor and connected to the signal line, wherein the first semiconductor layer is an n+-type diffusion layer; a second semiconductor layer formed above and adjacent to the first semiconductor layer, wherein the second semiconductor layer is a p-tpye impurity-doped region; a gate connected to the second semiconductor layer through an insulating film; a charge storage section comprised of a third semiconductor layer connected to the second semiconductor layer and adapted, in response to receiving light, to undergo a change in amount of electric charges therein, wherein the third semiconductor layer is an n-type diffusion layer; and a fourth semiconductor layer formed above and adjacent to the second and third semiconductor layers, wherein the fourth semiconductor layer is a p+-type diffusion layer; and a pixel selection line connected to the fourth semiconductor layer formed as a top portion of the island-shaped semiconductor wherein the second semiconductor layer has a first portion and a second portion, wherein the gate is formed to surround an outer periphery of the first portion of the second semiconductor layer through the insulating film, and the third semiconductor layer is formed to surround an outer periphery of the second portion of the second semiconductor layer, wherein the gate is part of a reset line of the imaging device.

In the solid-state imaging device, a combination of the third and fourth semiconductor layers functions as a photoelectric-conversion photoiode, and a combination of the second, third and fourth semiconductors and a combination of the first, second and third semiconductor layers and the gate function as an amplification transistor and a reset transistor, respectively.

This makes it possible to form a unit pixel of a CMOS image sensor in an area of 4F² (F: minimum fabrication size) to achieve a CMOS image sensor with a high degree of pixel integration.

### BEST MODE FOR CARRYING OUT THE INVENTION

The present invention will now be described based on an embodiment illustrated in the drawings. However, it should be understood that the present invention is not limited to the following embodiment.

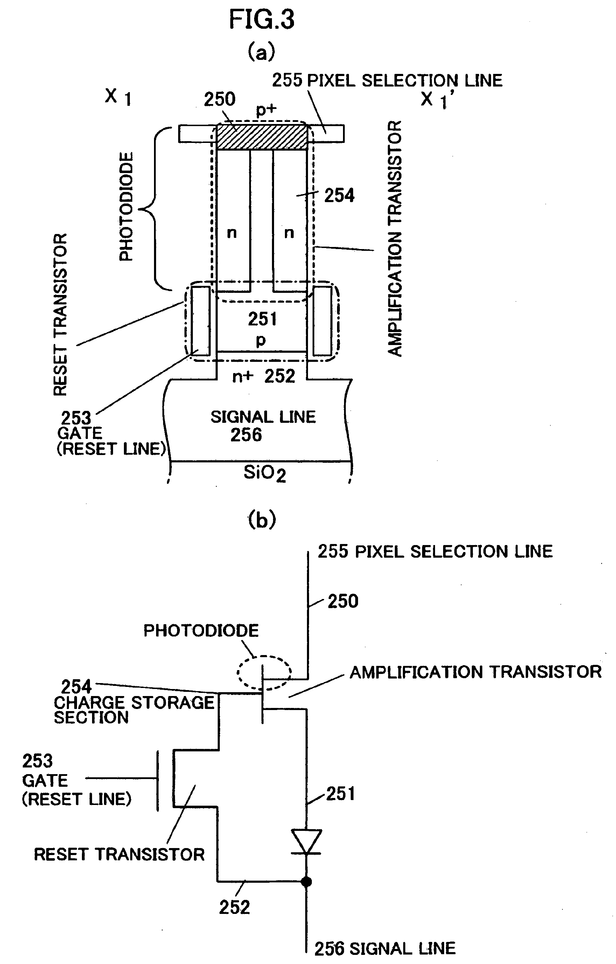

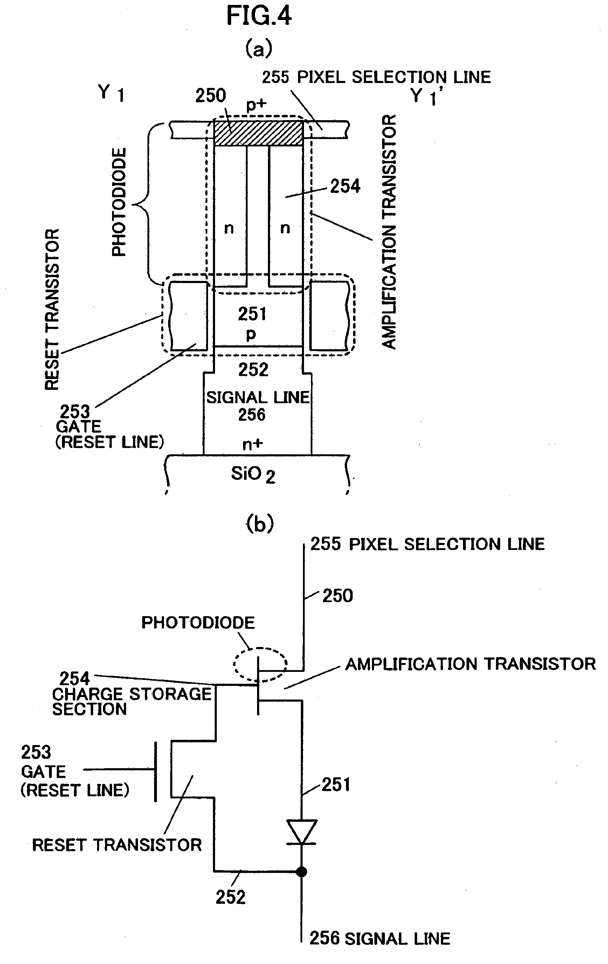

FIG. 2 is a perspective view showing one solid-state imaging device according to a first embodiment of the present invention. FIG. 3(a) is a sectional view taken along the line X₁-X'₁ in FIG. 2, and FIG. 3(b) is a schematic diagram showing an equivalent circuit of the cross-sectional structure in FIG. 3(a). FIG. 4(a) is a sectional view taken along the line Y₁-Y'₁ in FIG. 2, and FIG. 4(b) is a schematic diagram showing an equivalent circuit of the cross-sectional structure in FIG. 4(a).

An island-shaped semiconductor is formed on a Si substrate. An n+-type diffusion layer is formed underneath the island-shaped semiconductor and in contact with the Si substrate to serve as a signal line 256. An n+-type diffusion layer 252 is formed on the signal line 256, and a p-type impurity-doped region 251 is formed on the n+-type diffusion layer 252. A gate 253 is connected to the p-type impurity-doped region 251 through an insulating film. The gate 253 is formed such that a lower end thereof is located adjacent to an upper end of the n+-type diffusion layer 252.

The p-type impurity-doped region 251 has a first portion to which the gate 253 is connected, and a second portion located above the first portion. A charge storage section is comprised of an n-type diffusion layer 254 connected to the second portion of the p-type impurity-doped region 251 and adapted, in response to receiving light, to undergo a change in amount of electric charges therein. The gate 253 is formed such that an upper end thereof is located adjacent to a lower end of the n-type diffusion layer 254.

A p+-type diffusion layer 250 is formed in connected relation to the p-type impurity-doped region 251 and the n-type diffusion layer 254. The island-shaped semiconductor includes the n+-type diffusion layer 252, the p-type impurity-doped region 251, the gate 253, the n-type diffusion layer 254, and the p+-type diffusion layer 250.

A pixel selection line 255 is formed in connected relation to the p+-type diffusion layer 250 formed as a top portion of the island-shaped semiconductor.

A combination of the p+-type diffusion layer 250 and the n-type diffusion layer 254 functions as a photoelectric-conversion photodiode. A combination of the p+-type diffusion layer 250, the n-type diffusion layer 254 and the p-type impurity-doped region 251 functions as an amplification transistor. A combination of the n+-type diffusion layer 252, the p-type impurity-doped region 251, the n-type diffusion layer 254 and the gate 253 functions as a reset transistor.

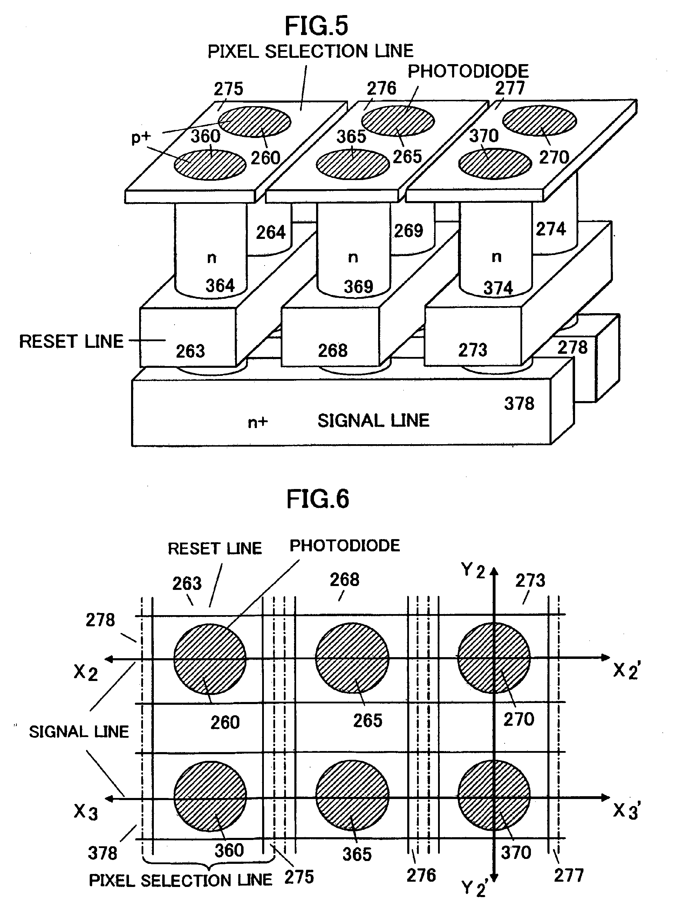

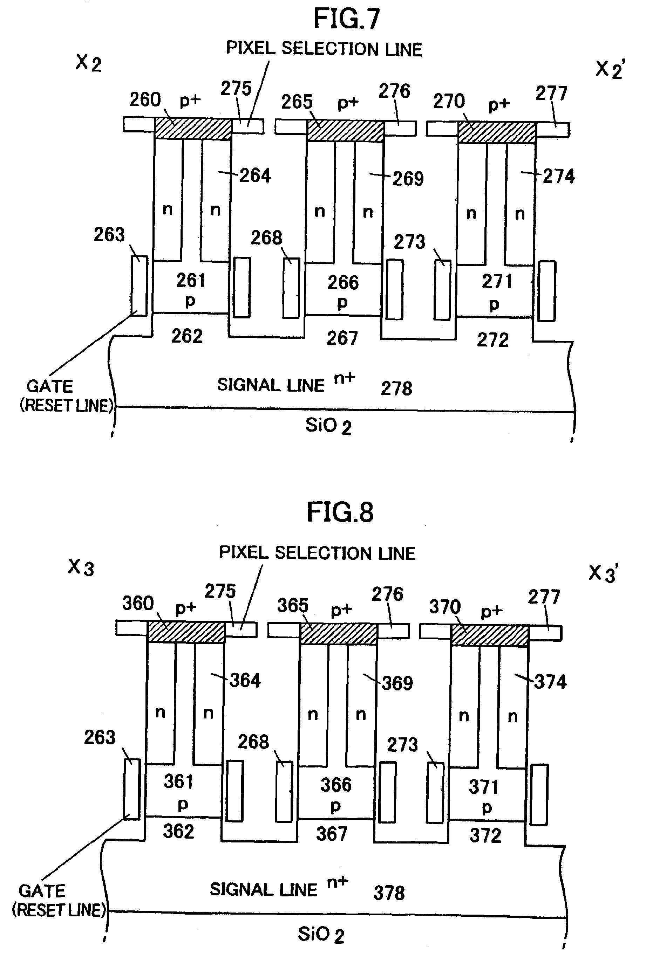

FIG. 5 is a perspective view showing a solid-state imaging device array having six sets of the above solid-state imaging devices which are arranged in a two-row by three-column array. FIG. 6 is a top plan view of the solid-state imaging device array. FIG. 7, FIG. 8 and FIG. 9 are a sectional view taken along the line X₂-X'₂ in FIG. 6, a sectional view taken along the line X₃-X'₃ in FIG. 6, and a sectional view taken along the line Y₂-Y'₂ in FIG. 6, respectively.

A solid-state imaging device at an intersection of the 1st row and the 1st column (1st-row/1st-column solid-state imaging device) comprises: an island-shaped semiconductor formed on a Si substrate; a p+-type diffusion layer 260, a p-type impurity-doped region 261 and an n+-type diffusion layer 262 each formed in the island-shaped semiconductor; a charge storage section 264 comprised of an n-type diffusion layer connected to the p-type impurity-doped region 261 and adapted, in response to receiving light, to undergo a change in amount of electric charges therein; a gate 263 connected to the p-type impurity-doped region 261 through an insulating film; and a pixel selection line 275 connected to the p+-type diffusion layer 260 formed as a top portion of the island-shaped semiconductor.

A solid-state imaging device at an intersection of the 1st row and the 2nd column (1st-row/2nd-column solid-state imaging device) comprises: an island-shaped semiconductor formed on the Si substrate; a p+-type diffusion layer 265, a p-type impurity-doped region 266 and an n+-type diffusion layer 267 each formed in the island-shaped semiconductor; a charge storage section 269 comprised of an n-type diffusion layer connected to the p-type impurity-doped region 266 and adapted, in response to receiving light, to undergo a change in amount of electric charges therein; a gate 268 connected to the p-type impurity-doped region 266 through an insulating film; and a pixel selection line 276 connected to the p+-type diffusion layer 265 formed as a top portion of the island-shaped semiconductor.

A solid-state imaging device at an intersection of the 1st row and the 3rd column (1st-row/3rd-column solid-state imaging device) comprises: an island-shaped semiconductor formed on the Si substrate; a p+-type diffusion layer 270, a p-type impurity-doped region 271 and an n+-type diffusion layer 272 each formed in the island-shaped semiconductor; a charge storage section 274 comprised of an n-type diffusion layer connected to the p-type impurity-doped region 271 and adapted, in response to receiving light, to undergo a change in amount of electric charges therein; a gate 273 connected to the p-type impurity-doped region 271 through an insulating film; and a pixel selection line 277 connected to the p+-type diffusion layer 270 formed as a top portion of the island-shaped semiconductor.

A solid-state imaging device at an intersection of the 2nd row and the 1st column (2nd-row/1st-column solid-state imaging device) comprises: an island-shaped semiconductor formed on the Si substrate; a p+-type diffusion layer 360, a p-type impurity-doped region 361 and an n+-type diffusion layer 362 each formed in the island-shaped semiconductor; a charge storage section 364 comprised of an n-type diffusion layer connected to the p-type impurity-doped region 361 and adapted, in response to receiving light, to undergo a change in amount of electric charges therein; the gate 263 connected to the p-type impurity-doped region 361 through an insulating film; and the pixel selection line 275 connected to the p+-type diffusion layer 361 formed as a top portion of the island-shaped semiconductor.

A solid-state imaging device at an intersection of the 2nd row and the 2nd column (2nd-row/2nd-column solid-state imaging device) comprises: an island-shaped semiconductor formed on the Si substrate; a p+-type diffusion layer 365, a p-type impurity-doped region 366 and an n+-type diffusion layer 367 each formed in the island-shaped semiconductor; a charge storage section 369 comprised of an n-type diffusion layer connected to the p-type impurity-doped region 366 and adapted, in response to receiving light, to undergo a change in amount of electric charges therein; the gate 268 connected to the p-type impurity-doped region 366 through an insulating film; and the pixel selection line 276 connected to the p+-type diffusion layer 365 formed as a top portion of the island-shaped semiconductor.

A solid-state imaging device at an intersection of the 2nd row and the 3rd column (2nd-row/3rd-column solid-state imaging device) comprises: an island-shaped semiconductor formed on the Si substrate; a p+-type diffusion layer 370, a p-type impurity-doped region 371 and an n+-type diffusion layer 372 each formed in the island-shaped semiconductor; a charge storage section 374 comprised of an n-type diffusion layer connected to the p-type impurity-doped region 371 and adapted, in response to receiving light, to undergo a change in amount of electric charges therein; the gate 273 connected to the p-type impurity-doped region 371 through an insulating film; and the pixel selection line 277 connected to the p+-type diffusion layer 370 formed as a top portion of the island-shaped semiconductor.

The pixel selection line 275 is formed to interconnect the p+-type diffusion layer 260 as the top portion of the island-shaped semiconductor in the 1st-row/1st-column solid-state imaging device, and the p+-type diffusion layer 360 as the top portion of the island-shaped semiconductor in the 2nd-row/1st-column solid-state imaging device. The pixel selection line 276 is formed to interconnect the p+-type diffusion layer 265 as the top portion of the island-shaped semiconductor in the 1st-row/2nd-column solid-state imaging device, and the p+-type diffusion layer 365 as the top portion of the island-shaped semiconductor in the 2nd-row/2nd-column solid-state imaging device. The pixel selection line 277 is formed to interconnect the p+-type diffusion layer 270 as the top portion of the island-shaped semiconductor in the 1st-row/3rd-column solid-state imaging device, and the p+-type diffusion layer 370 as the top portion of the island-shaped semiconductor in the 2nd-row/3rd-column solid-state imaging device.

Further, a signal line 278 is formed to interconnect the n+-type diffusion layer 262 as a bottom portion of the island-shaped semiconductor in the 1st-row/1st-column solid-state imaging device, the n+-type diffusion layer 267 as a bottom portion of the island-shaped semiconductor in the 1st-row/2nd-column solid-state imaging device, and the n+-type diffusion layer 272 as a bottom portion of the island-shaped semiconductor in the 1st-row/3rd-column solid-state imaging device, and a signal line 378 is formed to interconnect the n+-type diffusion layer 362 as a bottom portion of the island-shaped semiconductor in the 2nd-row/1st-column solid-state imaging device, the n+-type diffusion layer 367 as a bottom portion of the island-shaped semiconductor in the 2nd-row/2nd-column solid-state imaging device, and the n+-type diffusion layer 372 as a bottom portion of the island-shaped semiconductor in the 2nd-row/3rd-column solid-state imaging device.

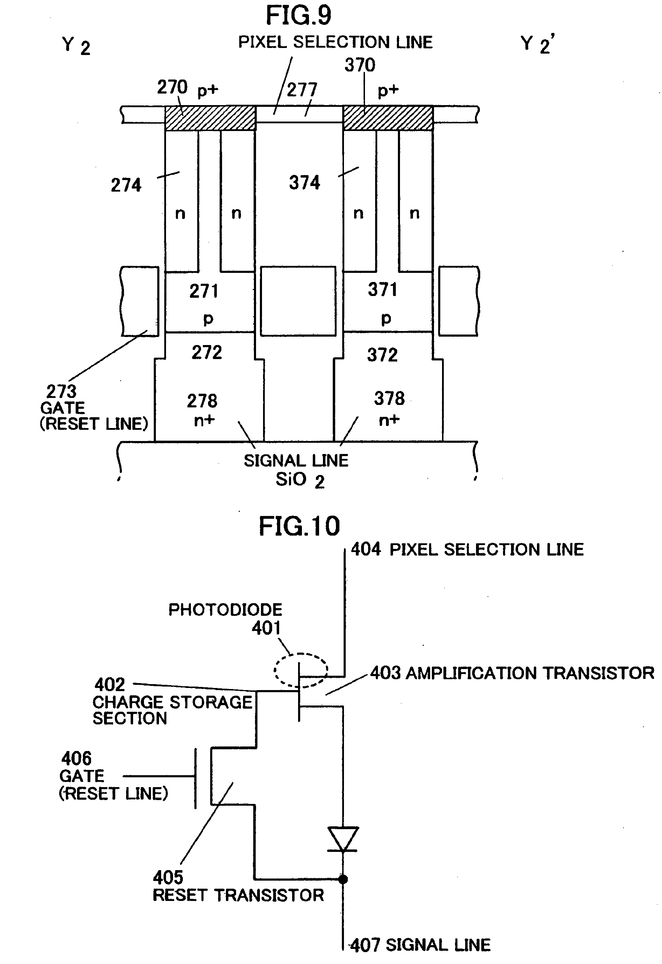

FIG. 10 shows an equivalent circuit of a solid-state imaging device according to the present invention. The solid-state imaging device according to the present invention comprises
a photodiode 401 comprised of the gate and source of an amplification transistor,
a charge storage section 402 comprised of the gate of the amplification transistor,
an amplification transistor 403 comprised of a junction transistor which amplifies the charge of the charge storage section,
a pixel selection line 404 connected to the source of the junction transistor,
a reset transistor 405, the source of which is connected to the gate of the amplification transistor, and comprised of a MOS transistor which resets the charge storage section,
a gate (reset line) 406,
a diode, the anode of which is connected to the drain of the amplification transistor and the cathode of which is connected to the drain of the reset transistor, and
a signal line 407 connected to the cathode of the diode.

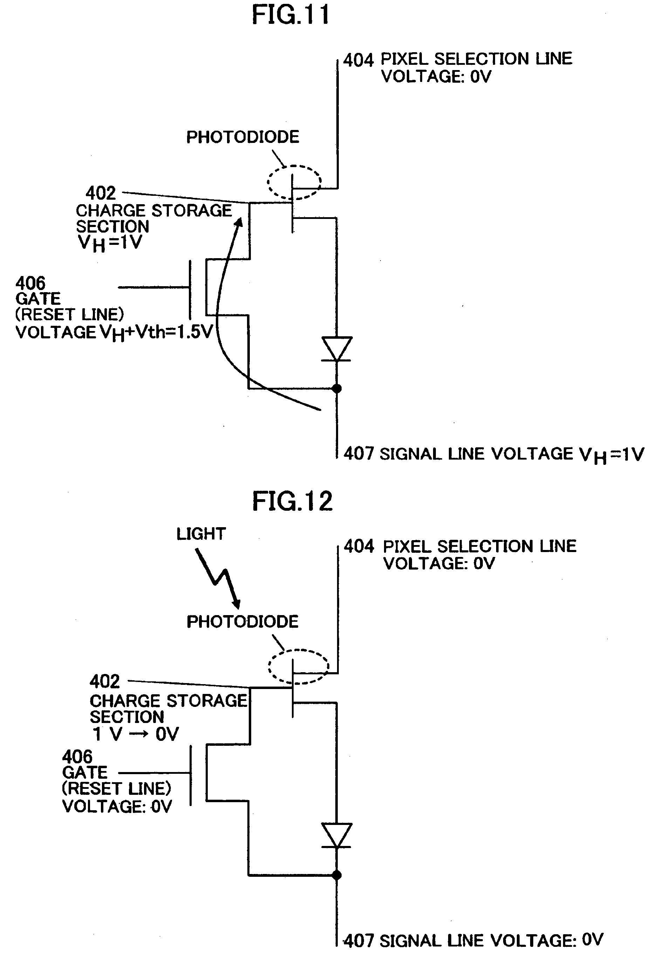

FIGS. 11, 12, 13(a) and 13(b) show a method of driving the solid-state imaging device according to the present invention.

Firstly, 0V, V_{H} (e.g., 1V), and V_{H} +Vth, are applied to the pixel selection line 404, the signal line 407, and the gate (reset line) 406, respectively, to allow the charge storage section 402 to be set at V_{H} so as to perform an operation of resetting the charge storage section 402 (FIG. 11), wherein Vth is a threshold voltage of the reset transistor, and set, for example, at 0.5V.

Then, 0V is applied to respective ones of the pixel selection line 404, the gate (reset line) 406 and the signal line 407, to convert a light signal incident onto the photodiode 401, into electric charges and store the converted signal charges in the charge storage section 402. Specifically, in response to receiving light, the voltage of the charge storage section is reduced (FIG. 12).

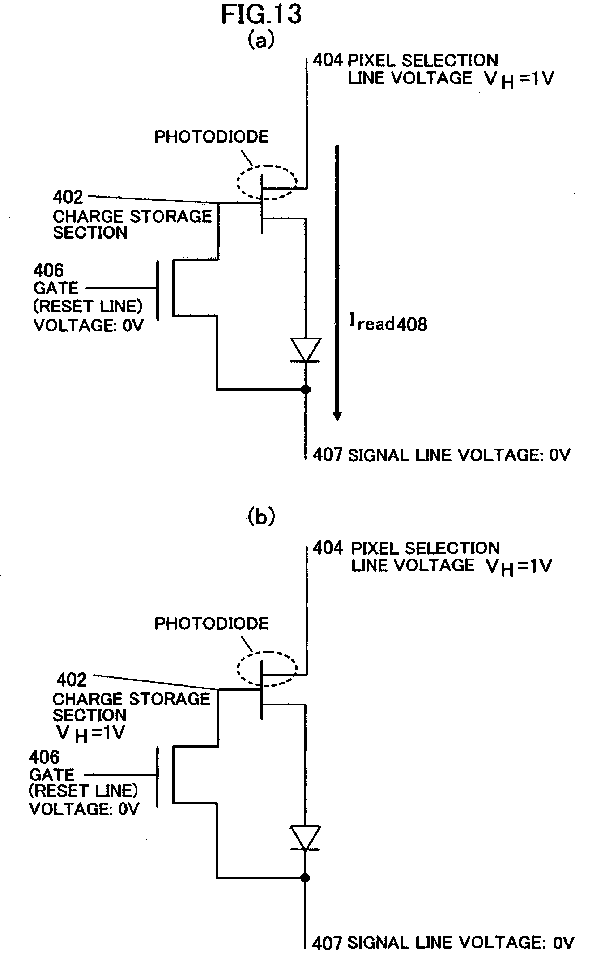

Then, V_{H} (e.g., 1V) is applied to the pixel selection line 404, and 0V is applied to respective ones of the gate (reset line) 406, and the signal line 407, to produce a flow of readout current T_{read} while amplifying the electric charges stored in the charge storage section 402, so as to perform a readout operation. Along with an increase in intensity of incident light, the voltage of the charge storage section 402 becomes lower to facilitate the current flow (FIG. 13(a)). If no light enters the photodiode, a voltage of the charge storage section 402 is maintained at V_{H} (e.g., 1V), so that no current flows (FIG. 13(b).

In the above driving method, after electric charges generated by a photoelectric conversion section made up of the photodiode are stored in the charge storage section, the stored electric charges can be amplified through an amplification section, and the amplified electric charges can be read out using the pixel selection section.

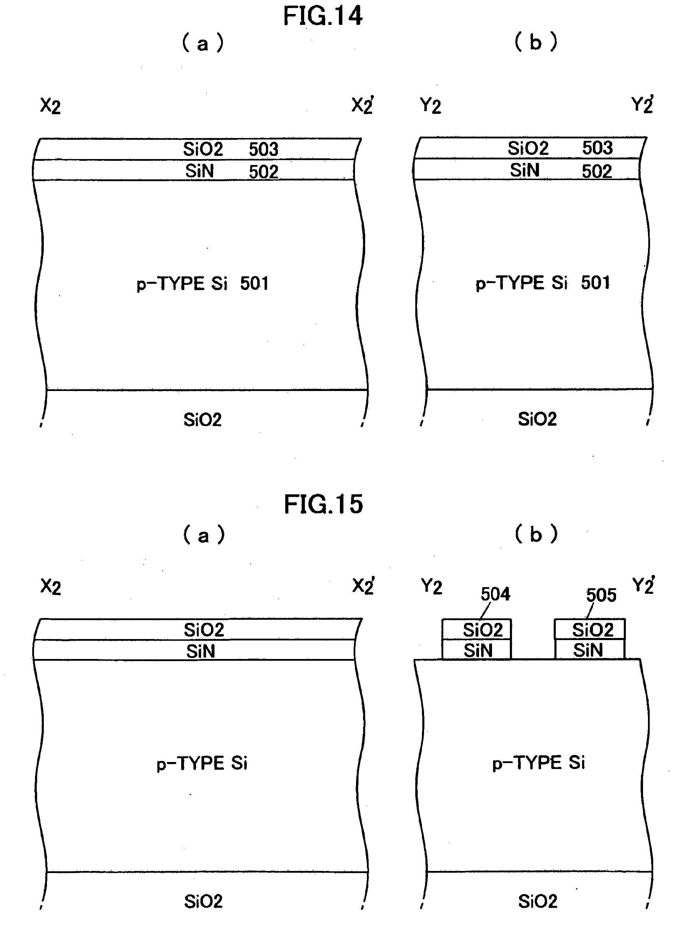

With reference to FIGS. 14(a) to 43(b), one example of a fabrication process for forming a structure of the solid-state imaging device according to the present invention will be described below.

FIGS. 14(a), 15(a), ---, and 43(a) correspond to the X₂-X'₂ section in FIG. 6, and FIGS. 14(b), 15(b), ---, and 43(b) correspond to the Y₂-Y'₂ section in FIG. 6.

FIGS. 14(a) and 14(b) are, respectively, the X₂-X'₂ section and the Y₂-Y'₂ section of a silicon-on-insulator (SOI) substrate where a silicon nitride (SiN) film 502 is deposited on a p-type silicon layer 501 formed on a silicon oxide film, and a silicon oxide film 503 is deposited on the silicon nitride film 502.

After forming a resist, the oxide film is etched, and the nitride film is etched. Then, the resist is removed to form a mask (504, 505) (FIGS. 15(a) and 15(b)).

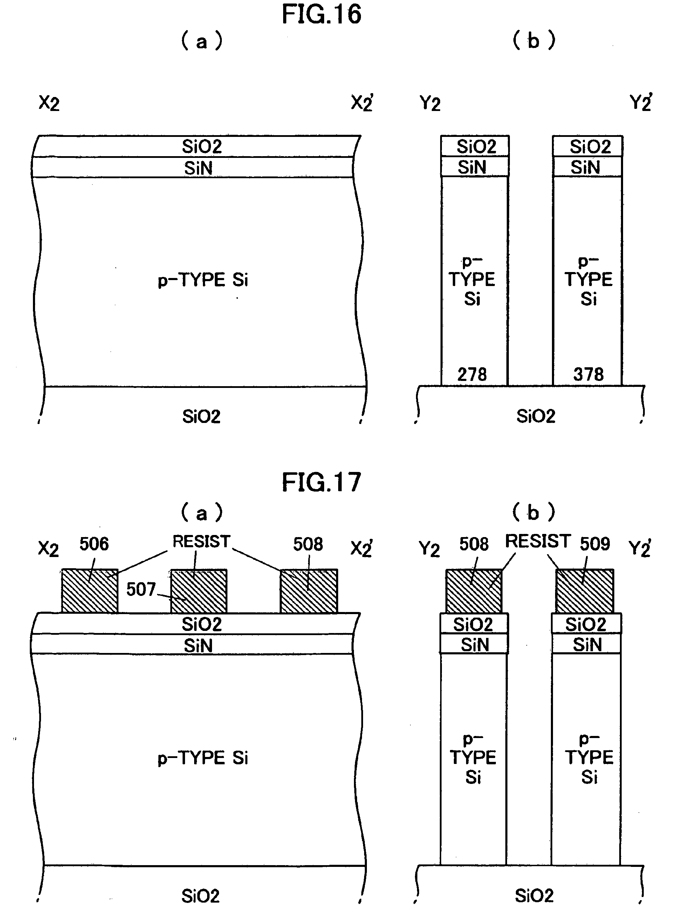

The Si layer 501 is etched to form a signal line (278, 378) (FIGS. 16(a) and 16(b)).

A resist (506, 507, 508, 509, --) is formed (FIGS. 17(a) and 17(b)).

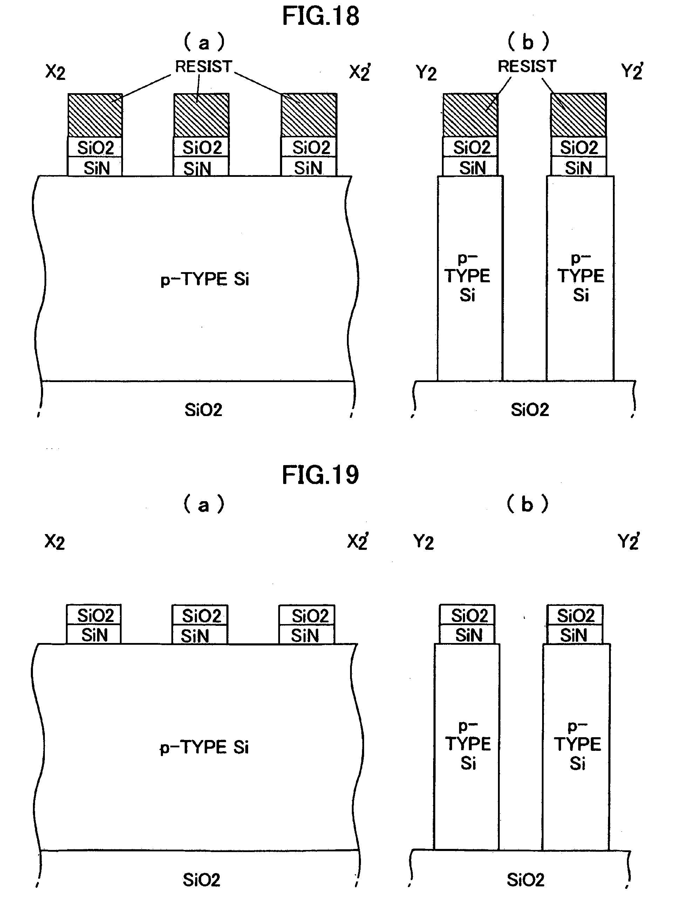

The oxide film and the nitride film are etched (FIGS. 18(a) and 18(b)).

The resist is removed (FIGS. 19(a) and 19(b)).

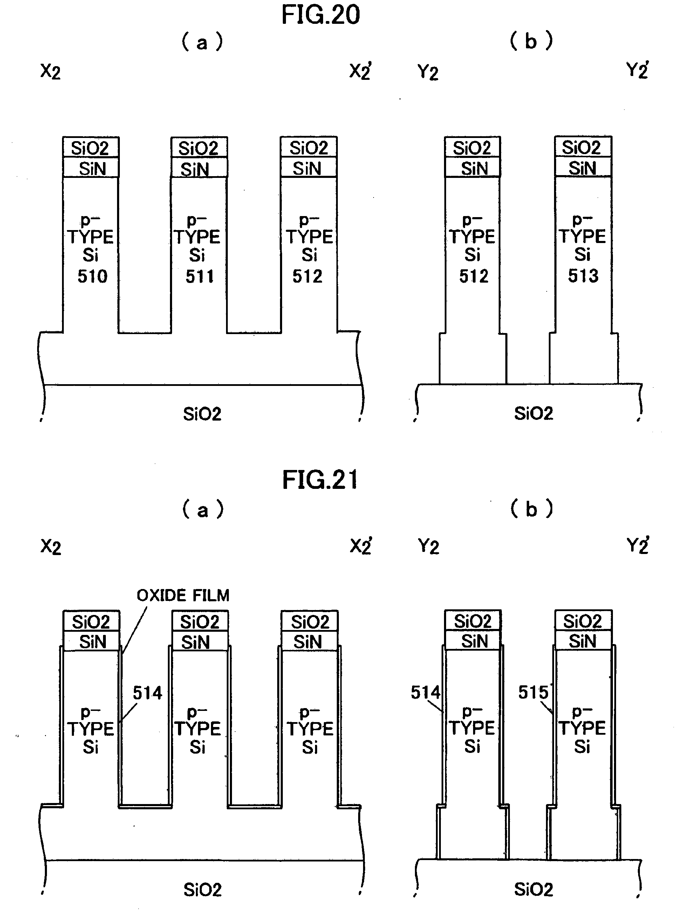

The Si layer is etched to form an island-shaped semiconductor (510, 511, 512, 513, --) (FIGS. 20(a) and 20(b)).

An oxidation treatment is performed to form an oxide film (514, 515) (FIGS. 21(a) and 21(b)).

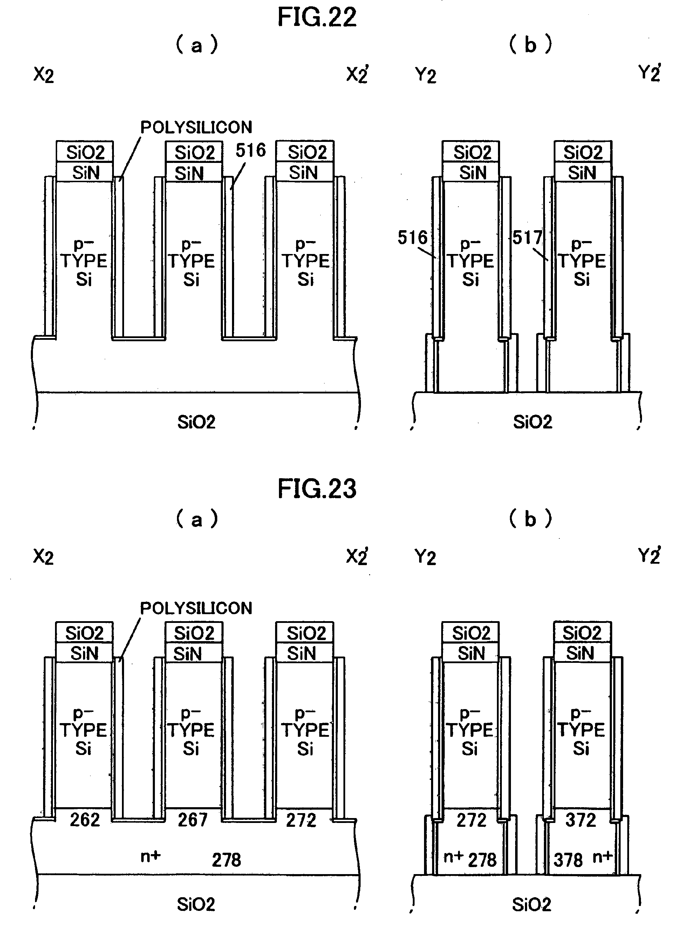

Polysilicon is deposited and then etched in such a manner that it is left as a sidewall (516, 517) (FIGS. 22(a) and 22(b)).

Phosphorus (P) is ion-implanted, and then an annealing treatment is performed to form a P-doped signal line (278, 378) and an n+-type diffusion layer (262, 267, 272, 372, --) (FIGS. 23(a) and 23(b)).

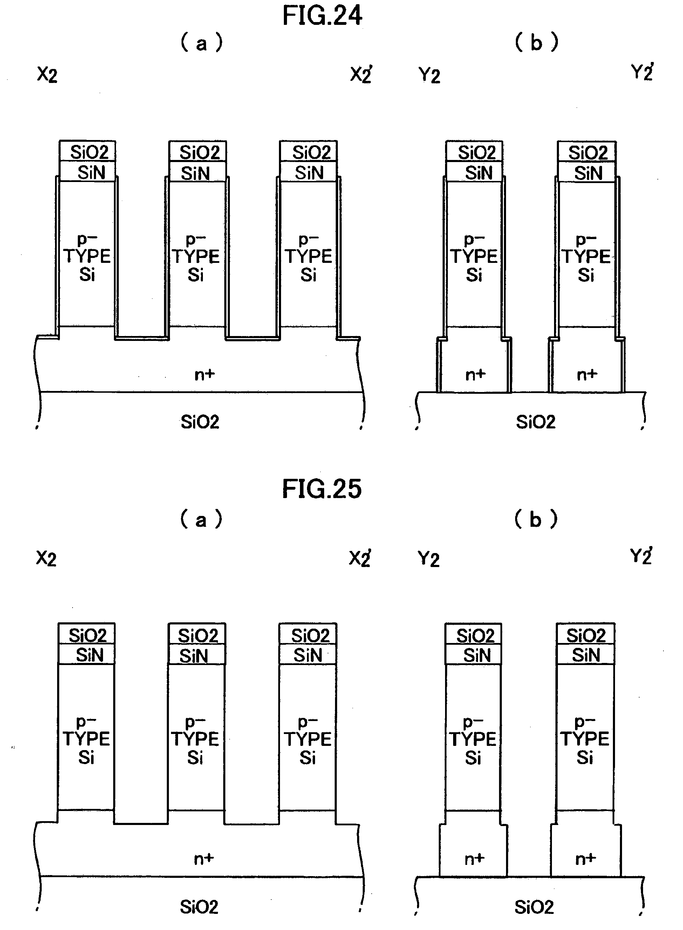

The polysilicon is removed (FIGS. 24(a) and 24(b)).

The oxide film (514, 515) is removed (FIGS. 25(a) and 25(b)).

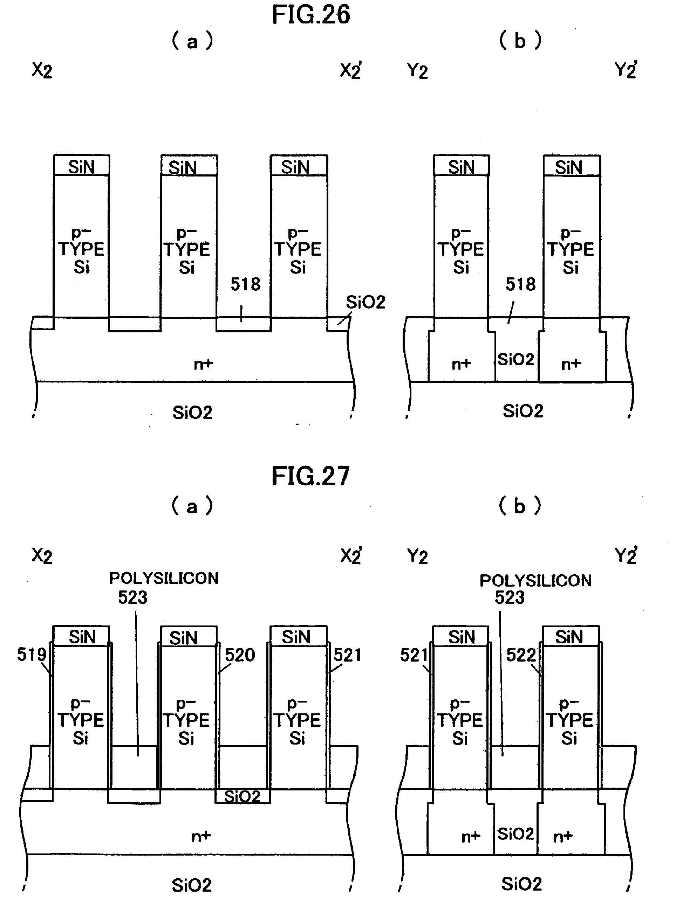

An oxide film is deposited, and, after being flattened, etched back to form an oxide film layer 518 (FIGS. 26(a) and 26(b)).

An oxidation treatment is performed to form a gate oxide film (519, 520, 521, 522, --). Then, polysilicon 523 is deposited, and, after being flattened, etched back (FIGS. 27(a) and 27(b)).

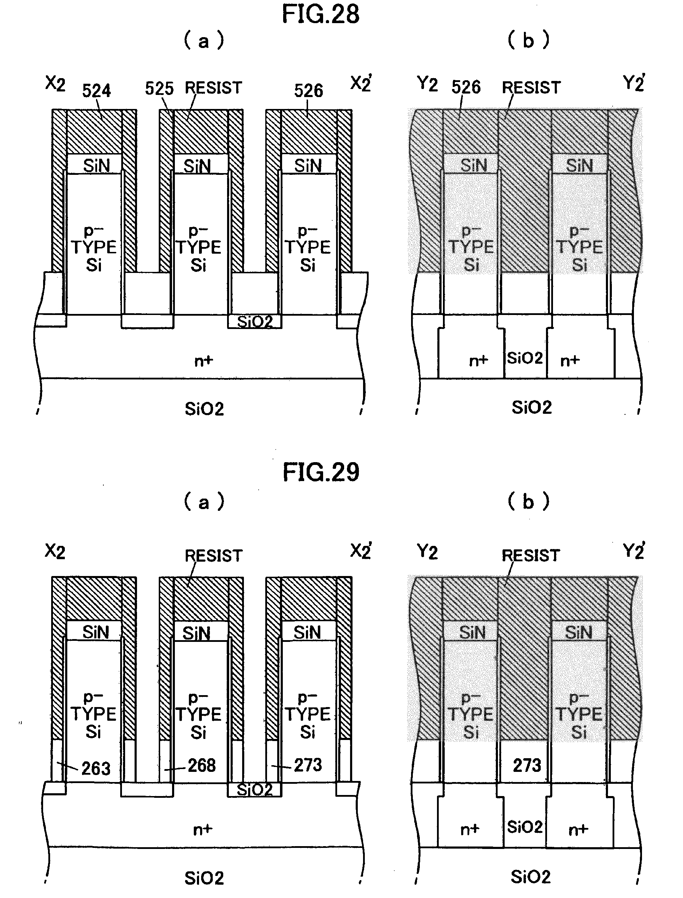

A resist (524, 525, 526) for a reset line is formed (FIGS. 28(a) and 28(b)).

The polysilicon is etched to form a gate (reset line) (263, 268, 273) (FIGS. 29(a) and 29(b)).

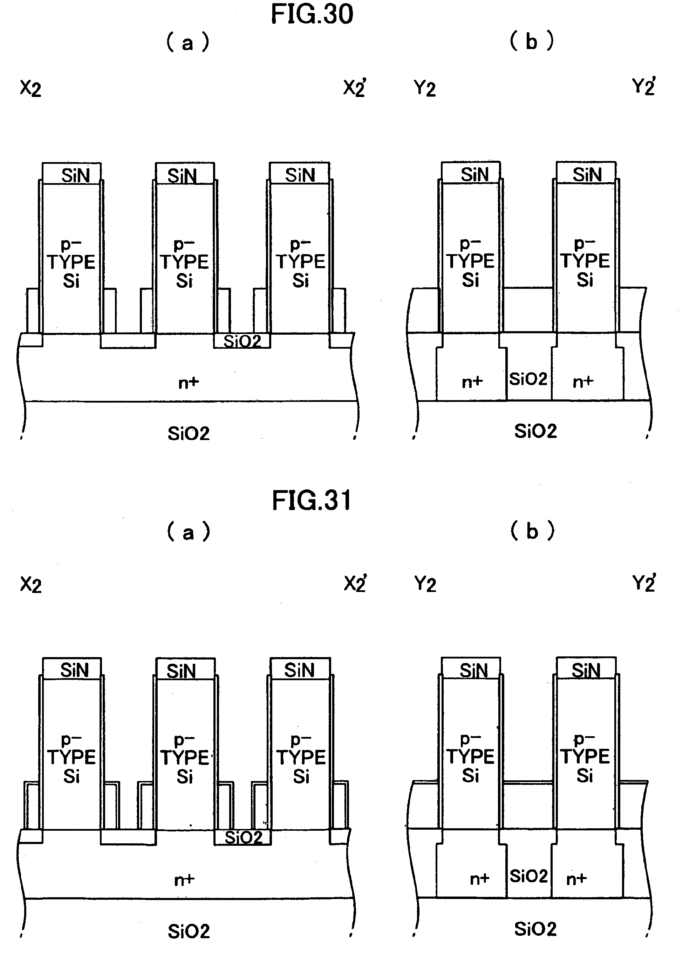

The resist is removed (FIGS. 30(a) and 30(b)).

After removing the thin oxide film on a sidewall of the Si pillar, the sidewall of the Si pillar, and the polysilicon gate, are surface-oxidized (FIGS. 31(a) and 31(b)).

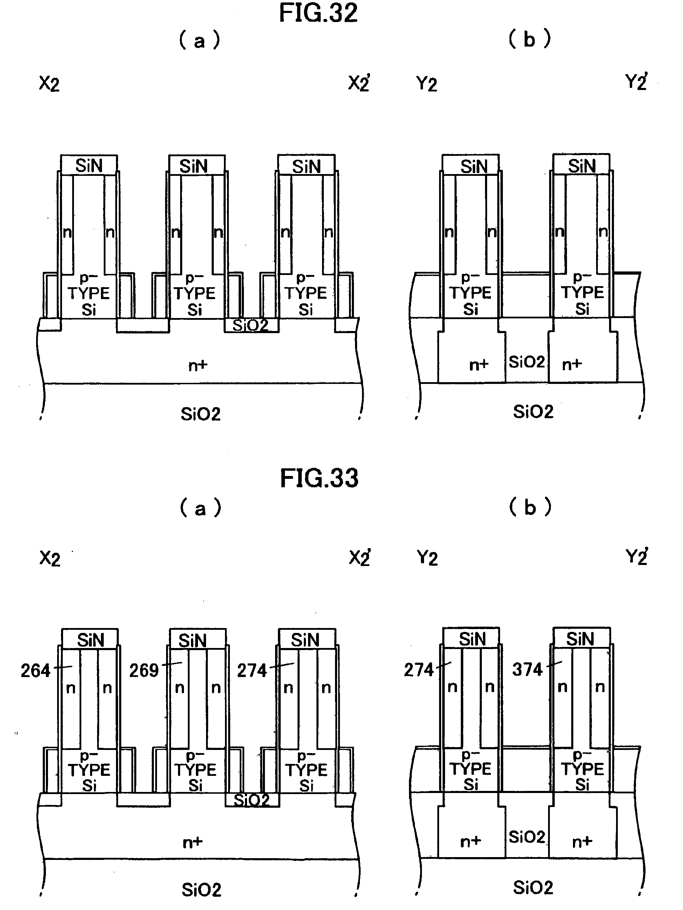

Phosphorus (P) is ion-implanted to form an n-type diffusion layer (FIGS. 32(a) and 32(b)).

An annealing treatment is performed to form a charge storage layer (264, 269, 274, 374, --) (FIGS. 33(a) and 33(b)).

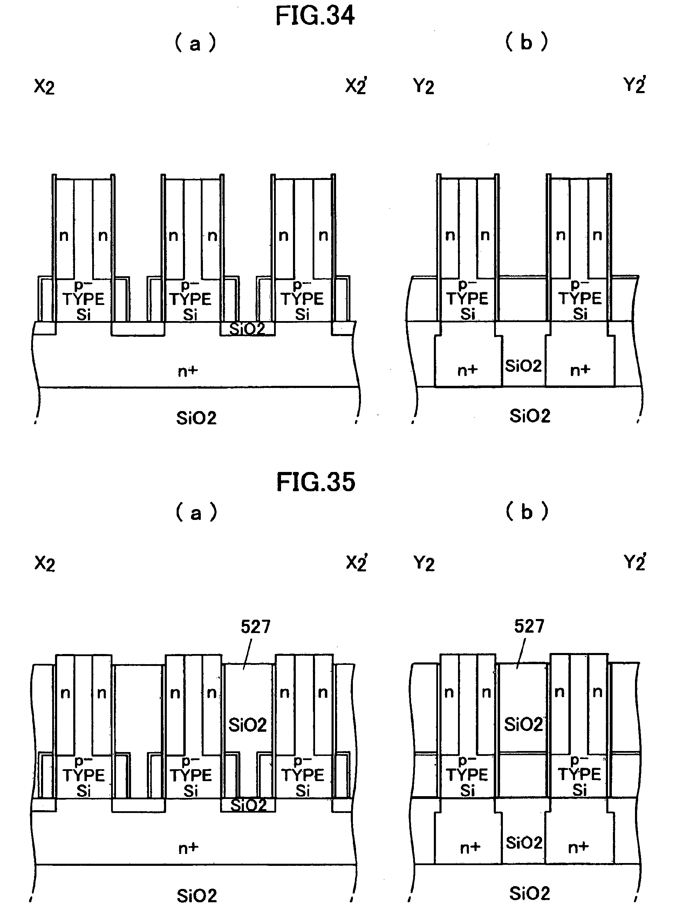

The nitride film is removed (FIGS. 34(a) and 34(b)).

An oxide film is deposited, and, after being flattened, etched back to form an oxide film layer 527 (FIGS. 35(a) and 35(b)).

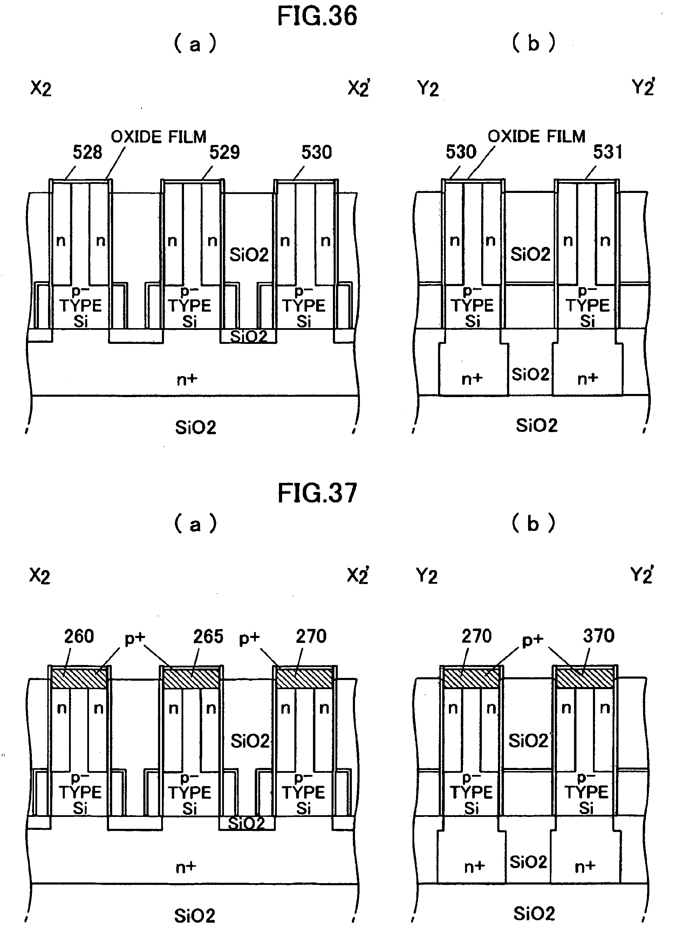

An oxidation treatment is performed to form an oxide film (528, 529, 530, 531, --) (FIGS. 36(a) and 36(b)).

Boron (B) is implanted, and then an annealing treatment is performed to form a p+-type diffusion layer (260, 265, 270, 370, --) (FIGS. 37(a) and 37(b)).

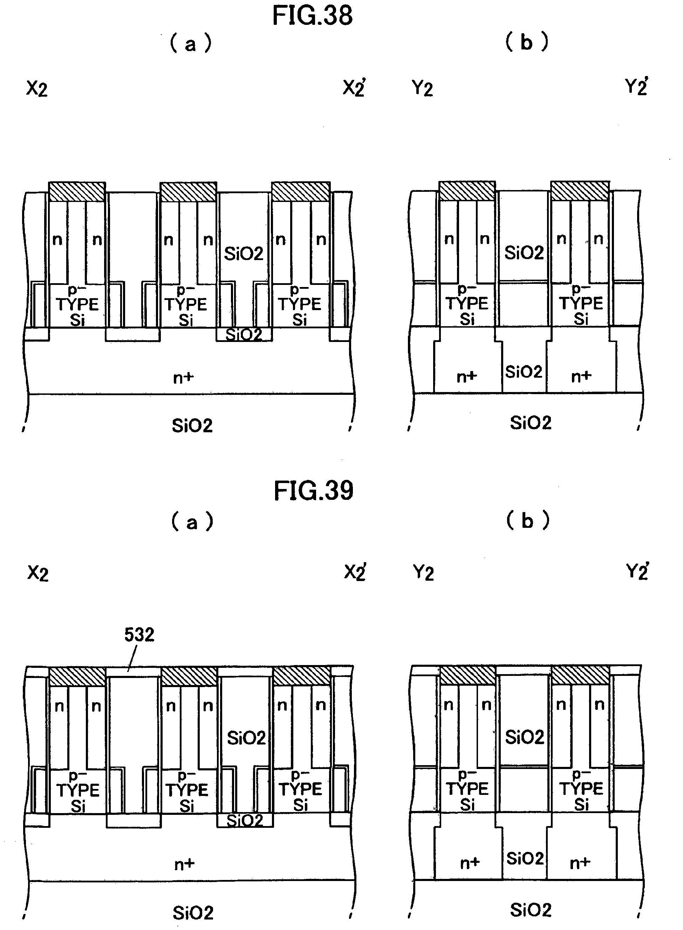

The oxide film is removed (FIGS. 38(a) and 38(b)).

A metal 532 is deposited, and, after being flattened, etched back (FIGS. 39(a) and 39(b)).

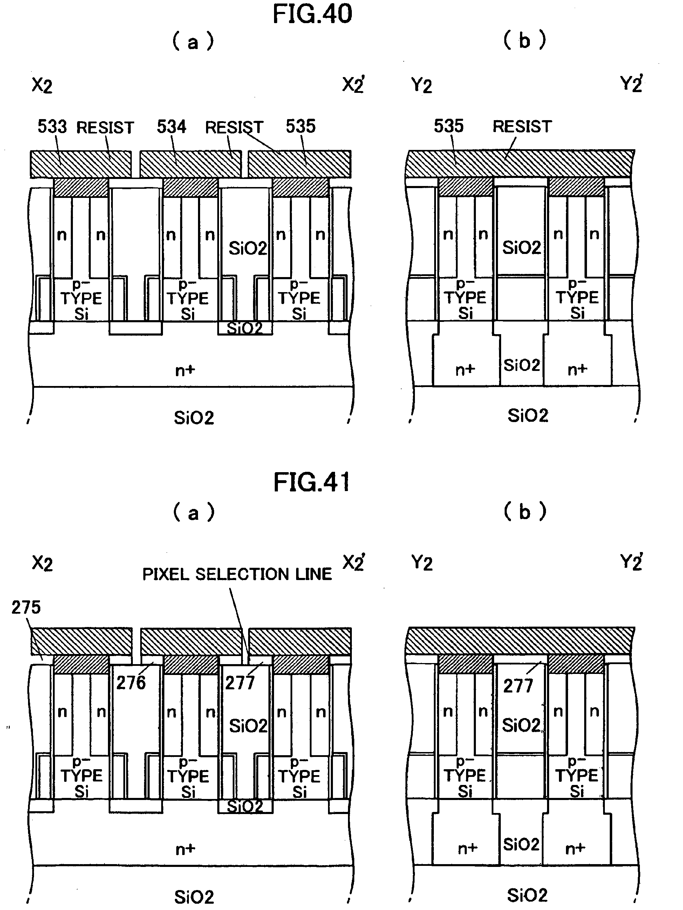

A resist (533, 534, 535) for a pixel selection layer is formed (FIGS. 40(a) and 40(b)).

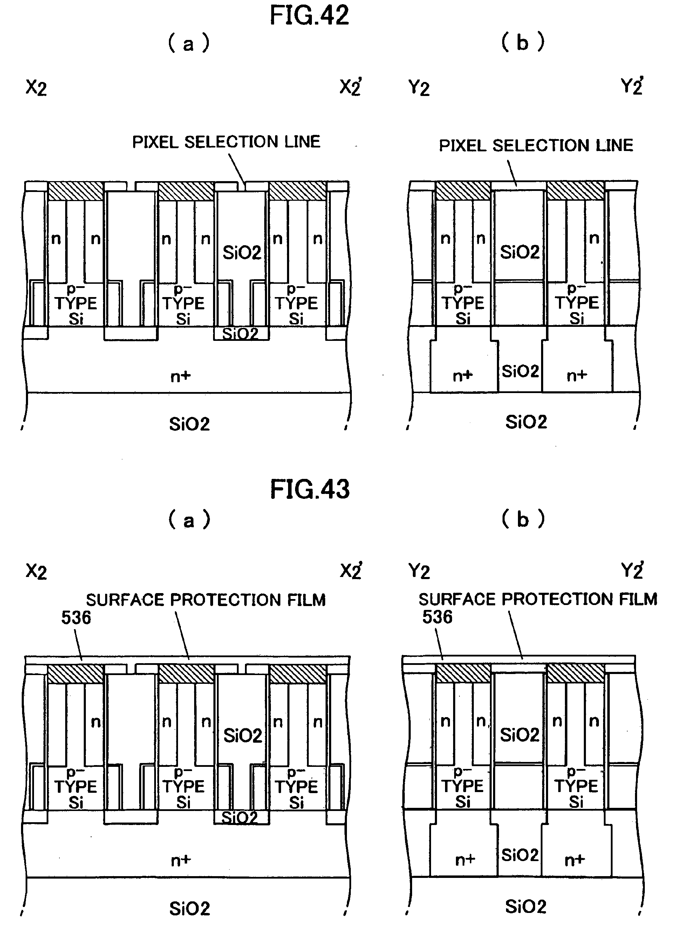

The metal is etched to form the pixel selection layer (275, 276, 277) (FIGS. 41 (a) and 42(b)).

The resist is removed (FIGS. 42(a) and 42(b)).

A surface protection film 536 is formed (FIGS. 43(a) and 43(b)).

The solid-state imaging device according to the first embodiment employs a structure where the charge storage section surrounds the p-type impurity-doped region, and the gate surrounds the p-type impurity-doped region through the insulating film.

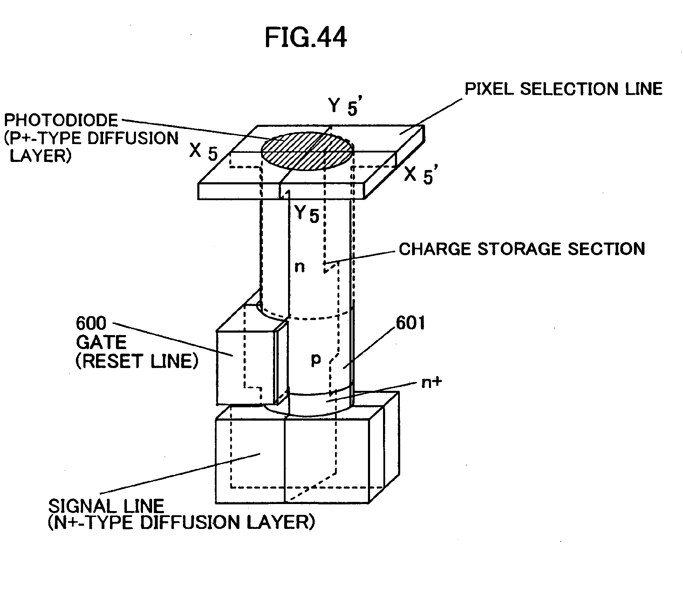

Alternatively, according to a not claimed example, as shown in FIG. 44, a gate 600 may be formed to surround a part of a p-type impurity-doped region 601 through an insulating film.

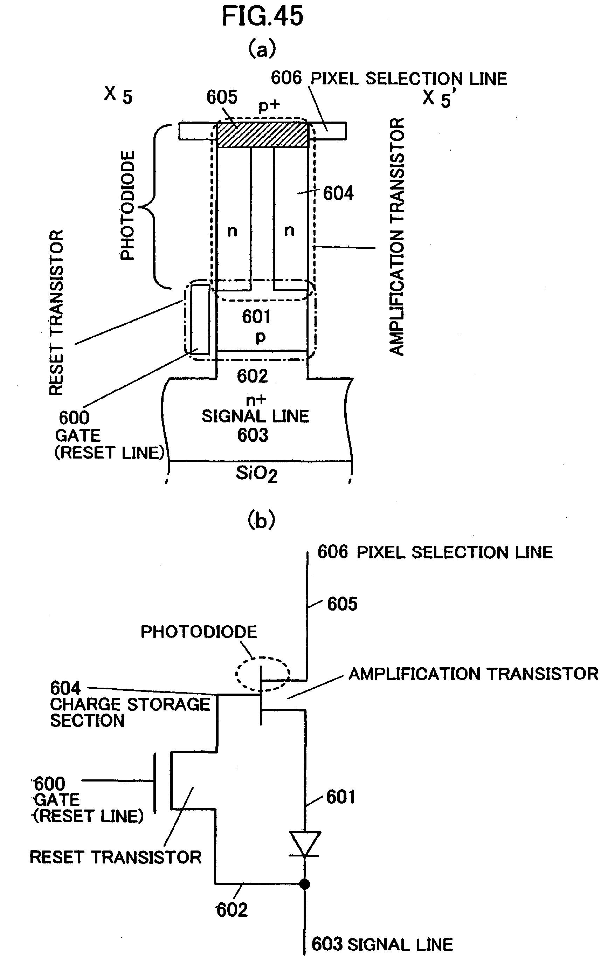

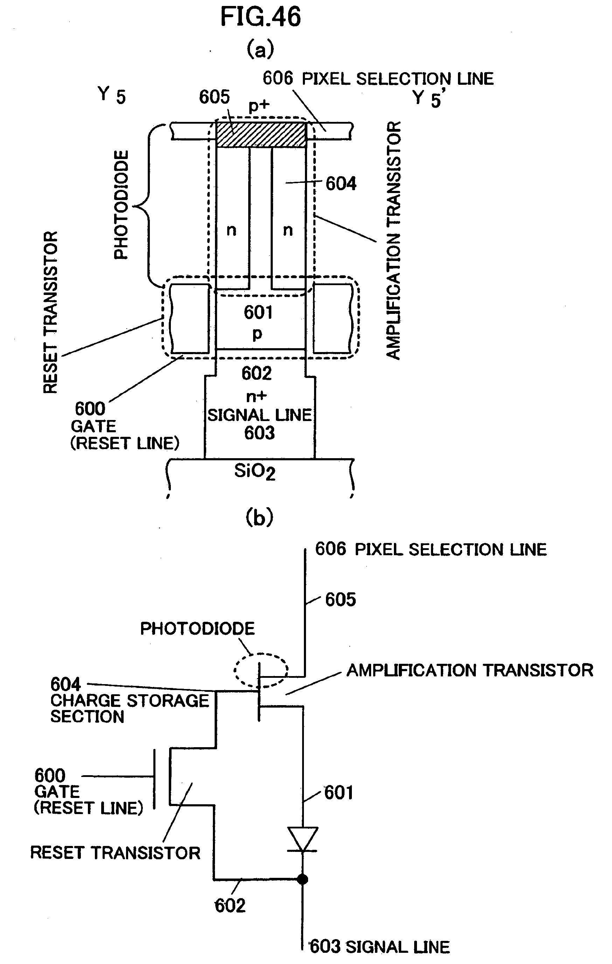

FIG. 44 is a perspective view showing an example. FIG. 45(a) is a sectional view taken along the line X₅-X'₅ in FIG. 44, and FIG. 45(b) is a schematic diagram showing an equivalent circuit of the cross-sectional structure in FIG. 45(a). FIG. 46(a) is a sectional view taken along the line Y₅-Y'₅ in FIG. 44, and FIG. 46(b) is a schematic diagram showing an equivalent circuit of the cross-sectional structure in FIG. 46(a).

Specifically, a solid-state imaging device according to the example comprises: an island-shaped semiconductor formed on a Si substrate; a p+-type diffusion layer 605, a p-type impurity-doped region 602 and an n+-type diffusion layer 602 each formed in the island-shaped semiconductor; a charge storage section 604 comprised of an n-type diffusion layer connected to the p-type impurity-doped region and adapted, in response to receiving light, to undergo a change in amount of electric charges therein; a gate 600 connected to the p-type impurity-doped region through an insulating film; and a pixel selection line 606 connected to the p+-type diffusion layer formed as a top portion of the island-shaped semiconductor.

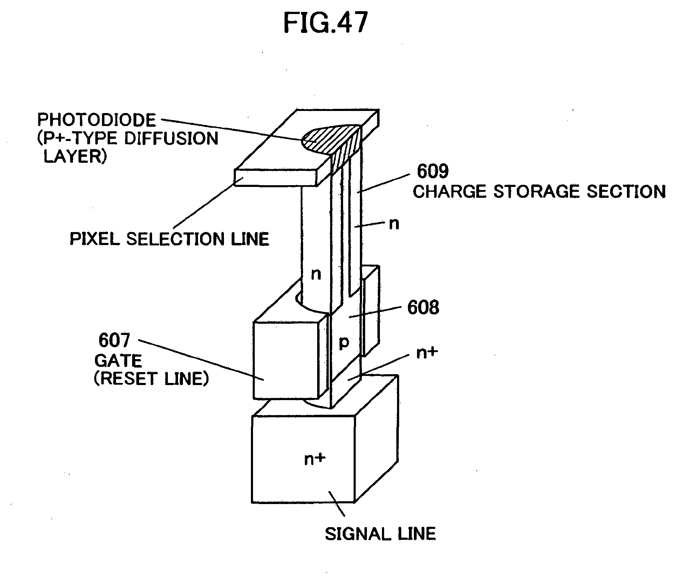

FIG. 47 shows an example. As shown in FIG. 47, a charge storage section 609 may be formed to surround a part of a p-type impurity-doped region 608, and a gate 607 may be formed to surround a part of the p-type impurity-doped region 608 through an insulating film.

As described above, a unit pixel of the conventional CMOS image sensor has a photodiode and three MOS transistors in a plane. This means that it is difficult to achieve a high degree of pixel integration.

In contrast, in the present invention, an island-shaped semiconductor is formed on a Si substrate, and a p+-type diffusion layer, a p-type impurity-doped region and an n+-type diffusion layer are formed in the island-shaped semiconductor. A charge storage section is comprised of an n-type diffusion layer connected to the p-type impurity-doped region and adapted, in response to receiving light, to undergo a change in amount of electric charges therein, and a gate is connected to the p-type impurity-doped region through an insulating film.

Further, a pixel selection line is connected to the p+-type diffusion layer formed as a top portion of the island-shaped semiconductor, and an n+-type diffusion layer is formed underneath the island-shaped semiconductor to serve as a signal line.

In the above solid-state imaging device, a combination of the p+-type diffusion layer and the n-type diffusion layer functions as a photoelectric-conversion photodiode. Further, a combination of the p+-type diffusion layer, the n-type diffusion layer and the p-type impurity-doped region functions as an amplification transistor, and a combination of the n+-type diffusion layer, the p-type impurity-doped region, the n-type diffusion layer and the gate functions as a reset transistor.

This structure makes it possible to form a photoelectric-conversion section, an amplification section, a pixel selection region and a reset section, i.e., a unit pixel of a CMOS image sensor, in an area of 4F² (F: minimum fabrication size) to achieve a CMOS image sensor with a high degree of pixel integration.

### BRIEF DESCRIPTION OF THE DRAWINGS

FIG. 1 is a schematic diagram showing an equivalent circuit of a unit pixel of a conventional CMOS image sensor.
FIG. 2 is a perspective view showing one solid-state imaging device according to a first embodiment of the present invention.
FIG. 3(a) is a sectional view taken along the line X₁-X'₁ in FIG. 2.
FIG. 3(b) is a schematic diagram showing an equivalent circuit of the cross-sectional structure in FIG. 3(a).
FIG. 4(a) is a sectional view taken along the line Y₁-Y'₁ in FIG. 2.
FIG. 4(b) is a schematic diagram showing an equivalent circuit of the cross-sectional structure in FIG. 4(a).
FIG. 5 is a perspective view showing a solid-state imaging device array in which six sets of the solid-state imaging devices according to the first embodiment are arranged in a two-row by three-column array.
FIG. 6 is a top plan view of the solid-state imaging device array.
FIG. 7 is a sectional view taken along the line X₂-X'₂ in FIG. 6.
FIG. 8 is a sectional view taken along the line X₃-X'₃ in FIG. 6.
FIG. 9 is a sectional view taken along the line Y₂-Y'₂ in FIG. 6.
FIG. 10 is a schematic diagram showing an equivalent circuit of a solid-state imaging device according to the present invention.
FIG. 11 is an explanatory diagram showing a method of driving the solid-state imaging device according to the present invention.
FIG. 12 is an explanatory diagram showing the method of driving the solid-state imaging device according to the present invention.
FIGS. 13(a) and 13(b) are explanatory diagrams showing the method of driving the solid-state imaging device according to the present invention.
FIGS. 14(a) and 14(b) are, respectively, a sectional view (X₂-X'₂ section) and a sectional view (Y₂-Y'₂ section) showing a step in one example of a production method for a CMOS image sensor according to the present invention.
FIGS. 15(a) and 15(b) are, respectively, a sectional view (X₂-X'₂ section) and a sectional view (Y₂-Y'₂ section) showing a step in the example of the production method.
FIGS. 16(a) and 16(b) are, respectively, a sectional view (X₂-X'₂ section) and a sectional view (Y₂-Y'₂ section) showing a step in the example of the production method.
FIGS. 17(a) and 17(b) are, respectively, a sectional view (X₂-X'₂ section) and a sectional view (Y₂-Y'₂ section) showing a step in the example of the production method.
FIGS. 18(a) and 18(b) are, respectively, a sectional view (X₂-X'₂ section) and a sectional view (Y₂-Y'₂ section) showing a step in the example of the production method.
FIGS. 19(a) and 19(b) are, respectively, a sectional view (X₂-X'₂ section) and a sectional view (Y₂-Y'₂ section) showing a step in the example of the production method.
FIGS. 20(a) and 20(b) are, respectively, a sectional view (X₂-X'₂ section) and a sectional view (Y₂-Y'₂ section) showing a step in the example of the production method.
FIGS. 21(a) and 21(b) are, respectively, a sectional view (X₂-X'₂ section) and a sectional view (Y₂-Y'₂ section) showing a step in the example of the production method.
FIGS. 22(a) and 22(b) are, respectively, a sectional view (X₂-X'₂ section) and a sectional view (Y₂-Y'₂ section) showing a step in the example of the production method.
FIGS. 23(a) and 23(b) are, respectively, a sectional view (X₂-X'₂ section) and a sectional view (Y₂-Y'₂ section) showing a step in the example of the production method.
FIGS. 24(a) and 24(b) are, respectively, a sectional view (X₂-X'₂ section) and a sectional view (Y₂-Y'₂ section) showing a step in the example of the production method.
FIGS. 25(a) and 25(b) are, respectively, a sectional view (X₂-X'₂ section) and a sectional view (Y₂-Y'₂ section) showing a step in the example of the production method.
FIGS. 26(a) and 26(b) are, respectively, a sectional view (X₂-X'₂ section) and a sectional view (Y₂-Y'₂ section) showing a step in the example of the production method.
FIGS. 27(a) and 27(b) are, respectively, a sectional view (X₂-X'₂ section) and a sectional view (Y₂-Y'₂ section) showing a step in the example of the production method.
FIGS. 28(a) and 28(b) are, respectively, a sectional view (X₂-X'₂ section) and a sectional view (Y₂-Y'₂ section) showing a step in the example of the production method.
FIGS. 29(a) and 29(b) are, respectively, a sectional view (X₂-X'₂ section) and a sectional view (Y₂-Y'₂ section) showing a step in the example of the production method.
FIGS. 30(a) and 30(b) are, respectively, a sectional view (X₂-X'₂ section) and a sectional view (Y₂-Y'₂ section) showing a step in the example of the production method.
FIGS. 31(a) and 31(b) are, respectively, a sectional view (X₂-X'₂ section) and a sectional view (Y₂-Y'₂ section) showing a step in the example of the production method.
FIGS. 32(a) and 32(b) are, respectively, a sectional view (X₂-X'₂ section) and a sectional view (Y₂-Y'₂ section) showing a step in the example of the production method.
FIGS. 33(a) and 33(b) are, respectively, a sectional view (X₂-X'₂ section) and a sectional view (Y₂-Y'₂ section) showing a step in the example of the production method.
FIGS. 34(a) and 34(b) are, respectively, a sectional view (X₂-X'₂ section) and a sectional view (Y₂-Y'₂ section) showing a step in the example of the production method.
FIGS. 35(a) and 35(b) are, respectively, a sectional view (X₂-X'₂ section) and a sectional view (Y₂-Y'₂ section) showing a step in the example of the production method.
FIGS. 36(a) and 36(b) are, respectively, a sectional view (X₂-X'₂ section) and a sectional view (Y₂-Y'₂ section) showing a step in the example of the production method.
FIGS. 37(a) and 37(b) are, respectively, a sectional view (X₂-X'₂ section) and a sectional view (Y₂-Y'₂ section) showing a step in the example of the production method.
FIGS. 38(a) and 38(b) are, respectively, a sectional view (X₂-X'₂ section) and a sectional view (Y₂-Y'₂ section) showing a step in the example of the production method.
FIGS. 39(a) and 39(b) are, respectively, a sectional view (X₂-X'₂ section) and a sectional view (Y₂-Y'₂ section) showing a step in the example of the production method.
FIGS. 40(a) and 40(b) are, respectively, a sectional view (X₂-X'₂ section) and a sectional view (Y₂-Y'₂ section) showing a step in the example of the production method.
FIGS. 41(a) and 41(b) are, respectively, a sectional view (X₂-X'₂ section) and a sectional view (Y₂-Y'₂ section) showing a step in the example of the production method.
FIGS. 42(a) and 42(b) are, respectively, a sectional view (X₂-X'₂ section) and a sectional view (Y₂-Y'₂ section) showing a step in the example of the production method.
FIGS. 43(a) and 43(b) are, respectively, a sectional view (X₂-X'₂ section) and a sectional view (Y₂-Y'₂ section) showing a step in the example of the production method.
FIG. 44 is a perspective view showing a solid-state imaging device according to an example useful for understanding the present invention.
FIG. 45(a) is a sectional view taken along the line X₅-X'₅ in FIG. 44.
FIG. 45(b) is a schematic diagram showing an equivalent circuit of the cross-sectional structure in FIG. 45(a).
FIG. 46(a) is a sectional view taken along the line Y₅-Y'₅ in FIG. 44.
FIG. 46(b) is a schematic diagram showing an equivalent circuit of the cross-sectional structure in FIG. 46(a).
FIG. 47 is a perspective view showing a solid-state imaging device according to an example useful for understanding the present invention.

### EXPLANATION OF CODES

5: photoelectric-conversion photodiode
11: pixel-selection clock line
12: reset clock line
13: signal line
14: power supply line
101: amplification transistor
102: reset transistor
103: selection transistor
114: reset power supply line
250: p+-type diffusion layer
251: p-type impurity-doped region
252: n+-type diffusion layer
253: gate
254: charge storage section
255: pixel selection line
256: signal line
260: p+-type diffusion layer
261: p-type impurity-doped region
262: n+-type diffusion layer
263: gate
264: charge storage section
275: pixel selection line
265: p+-type diffusion layer
266: p-type impurity-doped region
267: n+-type diffusion layer
268: gate
269: charge storage section
276: pixel selection line
270: p+-type diffusion layer
271: p-type impurity-doped region
272: n+-type diffusion layer
273: gate
274: charge storage section
277: pixel selection line
278: signal line
360: p+-type diffusion layer
361: p-type impurity-doped region
362: n+-type diffusion layer
364: charge storage section
365: p+-type diffusion layer
366: p-type impurity-doped region
367: n+-type diffusion layer
369: charge storage section
370: P+-type diffusion layer
371: p-type impurity-doped region
372: n+-type diffusion layer
374: charge storage section
378: signal line
401: photodiode
402: charge storage section
403: amplification transistor
404: pixel selection line
405: reset transistor
406: gate
407: signal line
408: readout current I_{read}
501: p-type silicon
502: nitride (SiN) film
503: silicon oxide film
504: mask
505: mask
506: resist
507: resist
508: resist
509: resist
510: island-shaped semiconductor
511: island-shaped semiconductor
512: island-shaped semiconductor
513: island-shaped semiconductor
514: oxide film
515: oxide film
516: sidewall
517: sidewall
518: oxide film
519: gate oxide film
520: gate oxide film
521: gate oxide film
522: gate oxide film
523: polysilicon
524: resist
525: resist
526: resist
527: oxide film layer
528: oxide film
529: oxide film
530: oxide film
531: oxide film
532: metal
533: resist
534: resist
535: resist
536: surface protection layer
600: gate
601: p-type impurity-doped region
602: n+-type diffusion layer
603: signal line
604: charge storage section
605: p+-type diffusion layer
606: pixel selection line
607: gate
608: p-type impurity-doped region
609: charge storage section

## Claims

1. A solid-state imaging device comprising: a signal line (256) formed on a Si substrate, the signal line being an n+-type diffusion layer; an island-shaped semiconductor formed on the signal line (256), wherein the island-shaped semiconductor includes:
a first semiconductor layer (252) formed as a bottom portion of the island-shaped semiconductor and connected to the signal line (256), wherein the first semiconductor layer (252) is an n+-type diffusion layer;
a second semiconductor layer (251) formed above and adjacent to the first semiconductor layer (252), wherein the second semiconductor layer (251) is a p-type impurity-doped region;
a gate (253) connected to the second semiconductor layer (251) through an insulating film;
a charge storage section comprised of a third semiconductor layer (254) connected to the second semiconductor layer (251) and adapted, in response to receiving light, to undergo a change in amount of electric charge therein, wherein the third semiconductor layer (254) is an n-type diffusion layer; and
a fourth semiconductor layer(250) formed above and adjacent to the second and third semiconductor layers (251, 254), wherein the fourth semiconductor layer (250) is a p+-type diffusion layer; and
a pixel selection line (255) connected to the fourth semiconductor layer (250) formed as a top portion of the island-shaped semiconductor;
wherein the second semiconductor layer (251) has a first portion and a second portion, wherein the gate (253) is formed to surround an outer periphery of the first portion of the second semiconductor layer (251) through the insulating film to form together with the first semiconductor layer (252), the first portion of the second semiconductor layer (251) and the third semiconductor layer (254) a reset transistor of the imaging device, and the third semiconductor layer (254) is formed to surround an outer periphery of the second portion of the second semiconductor layer (251) to form together with the second semiconductor layer (251) and the fourth semiconductor layer (250) an amplification transistor of the imaging device.

2. The solid-state imaging device according to claim 1, wherein the first portion of the second semiconductor layer (251) is formed in a cross-sectionally-circular pillar shape.

3. The solid-state imaging device according to claim 1, wherein the second portion of the second semiconductor layer (251) is formed in a cross-sectionally-circular pillar shape.

4. A solid-state imaging device array comprising a plurality of the solid-state imaging devices according to claim 1, which are arranged on the substrate in an n-row by m-column array, wherein each of n and m is an integer of 1 or more.

5. A method of driving the solid-state imaging device according to claim 1, comprising the steps of applying a first drive voltage to the pixel selection line (255), applying a second drive voltage to the signal line (256) and applying a third drive voltage to the gate (253), to reset the charge storage section (254).

6. The method according to claim 5, which further comprises the step of receiving light, while applying the first drive voltage to respective ones of the pixel selection line (255), the gate (253) and the signal line (256), to change an amount of electric charges stored in the charge storage section (254).

7. The method according to claim 6, which further comprises the steps of:
applying the second drive voltage to the pixel selection line (255), applying the first drive voltage to the gate (253) and applying the first drive voltage to the signal line (256), to produce a flow of readout current while amplifying the electric charges stored in the charge storage section (254) and, so as to perform a readout operation.

8. The method according to claim 7, wherein:
the first drive voltage is set at zero V;
the second drive voltage is set at 1 V; and
the third drive voltage is set at 1.5 V.

## Patentansprüche

1. Festkörper-Bildgebungsvorrichtung umfassend: eine auf einem Si-Substrat ausgebildete Signalleitung (256), wobei die Signalleitung eine n+-Typ Diffusionsschicht ist; einen auf der Signalleitung (256) ausgebildeten inselförmigen Halbleiter, wobei der inselförmige Halbleiter umfasst:
eine erste Halbleiterschicht (252), welche als ein unterer Abschnitt des inselförmigen Halbleiters ausgebildet ist und mit der Signalleitung (256) verbunden ist, wobei die erste Halbleiterschicht (252) eine n+-Typ Diffusionsschicht ist;
eine zweite Halbleiterschicht (251), welche oberhalb und benachbart zur ersten Halbleiterschicht (252) ausgebildet ist, wobei die zweite Halbleiterschicht (251) eine p-Typ störstellendotierte Region ist;
ein Gate (253), welches durch einen isolierenden Film mit der zweiten Halbleiterschicht (251) verbunden ist;
einen Ladungsspeicherabschnitt, welcher eine mit der zweiten Halbleiterschicht (251) verbundene dritte Halbleiterschicht (254) umfasst und dazu ausgebildet ist, in Reaktion auf empfangenes Licht, darin eine Änderung in einer Menge an elektrischen Ladungsträgern zu erfahren, wobei die dritte Halbleiterschicht (254) als n-Typ Diffusionsschicht ausgebildet ist; und
eine vierte Halbleiterschicht (250), welche oberhalb und benachbart zu den zweiten und dritten Halbleiterschichten (251, 254) ausgebildet ist, wobei die vierte Halbleiterschicht (250) eine p+-Typ Diffusionsschicht ist; und
eine Pixelauswahlleitung (255), welche mit der vierten Halbleiterschicht (250) verbunden ist, die als oberer Abschnitt des inselförmigen Halbleiters ausgebildet ist; wobei die zweite Halbleiterschicht (251) einen ersten Abschnitt und einen zweiten Abschnitt aufweisen, wobei das Gate (253) ausgebildet ist, um einen Außenbereich des ersten Abschnitts der zweiten Halbleiterschicht (251) durch den isolierenden Film zu umgeben, um zusammen mit der ersten Halbleiterschicht (252), dem ersten Abschnitt der zweiten Halbleiterschicht (251) und der dritten Halbleiterschicht (254) einen Reset-Transistor der Bildgebungsvorrichtung zu bilden, und wobei die dritte Halbleiterschicht (254) ausgebildet ist, um einen Außenbereich des zweiten Abschnitts der zweiten Halbleiterschicht (251) zu umgeben, um zusammen mit der zweiten Halbleiterschicht (251) und der vierten Halbleiterschicht (250) einen Verstärkungstransistor der Bildgebungsvorrichtung zu bilden.

2. Festkörper-Bildgebungsvorrichtung nach Anspruch 1, wobei der erste Abschnitt der zweiten Halbleiterschicht (251) in einer Säulenform mit kreisförmigen Querschnitt ausgebildet ist.

3. Festkörper-Bildgebungsvorrichtung nach Anspruch 1, wobei der zweite Abschnitt der zweiten Halbleiterschicht (251) in einer Säulenform mit kreisförmigen Querschnitt ausgebildet ist.

4. Festkörper-Bildgebungsvorrichtungs-Array, umfassend eine Vielzahl an Festkörper-Abbildungsvorrichtungen nach Anspruch 1, welche auf dem Substrat in einem n-Zeilen mal m-Spalten-Array angeordnet sind, wobei n und m jeweils eine ganze Zahl größer als 1 ist.

5. Verfahren zum Betreiben der Festkörper-Bildgebungsvorrichtung nach Anspruch 1, umfassend die Schritte des Anlegens einer ersten Steuerspannung an die Pixelauswahlleitung (255), des Anlegens einer zweiten Steuerspannung an die Signalleitung (256) und des Anlegens einer dritten Steuerspannung an das Gate (253), um den Ladungsspeicherabschnitt (255) zurückzusetzen.

6. Verfahren nach Anspruch 5, welches ferner den Schritt des Empfangens von Licht umfasst, während die erste Steuerspannung jeweils an die Pixelauswahlleitung (255), an das Gate (253) und an die Signalleitung (256) angelegt wird, um eine Menge an im Ladungsspeicherabschnitt (254) gespeicherten elektrischen Ladungen zu ändern.

7. Verfahren nach Anspruch 6, welches ferner die Schritte umfasst:
Anlegen der zweiten Steuerspannung an die Pixelauswahlleitung (255), Anlegen der ersten Steuerspannung an das Gate (253) und Anlegen der ersten Steuerspannung an die Signalleitung (256), um einen Readout-Stromfluss zu erzeugen, während die im Ladungsspeicherabschnitt (254) gespeicherten elektrischen Ladungen verstärkt werden, um eine Readout-Operation durchzuführen.

8. Verfahren nach Anspruch 7, wobei
die erste Steuerspannung zu Null Volt eingestellt wird;
die zweite Steuerspannung zu 1 Volt eingestellt wird; und
die dritte Steuerspannung zu 1.5 Volt eingestellt wird.

## Revendications

1. Dispositif d'imagerie à semi-conducteurs comprenant : une ligne (256) de signaux formée sur un substrat de Si, la ligne de signaux étant une couche de diffusion de type n+ ; un semi-conducteur en forme d'île formé sur la ligne (256) de signaux, dans lequel le semi-conducteur en forme d'île inclut :
une première couche semi-conductrice (252) formée comme une partie de fond du semi-conducteur en forme d'île et connectée à la ligne (256) de signaux, dans lequel la première couche semi-conductrice (252) est une couche de diffusion de type n+ ;
une deuxième couche semi-conductrice (251) formée par-dessus et adjacente à la première couche semi-conductrice (252), dans lequel la deuxième couche semi-conductrice (251) est une région dopée avec une impureté de type p ;
une grille (253) connectée à la deuxième couche semi-conductrice (251) à travers un film d'isolation ;
une section de stockage de charge composée d'une troisième couche semi-conductrice (254) connectée à la deuxième couche semi-conductrice (251) et adaptée, en réponse à la réception d'une lumière, à subir un changement d'une quantité de charge électrique dans celle-ci, dans lequel la troisième couche semi-conductrice (254) est une couche de diffusion de type n ; et
une quatrième couche semi-conductrice (250) formée par-dessus et adjacente aux deuxième et troisième couches semi-conductrices (251, 254), dans lequel la quatrième couche semi-conductrice (250) est une couche de diffusion de type p+ ; et
une ligne (255) de sélection de pixels connectée à la quatrième couche semi-conductrice (250) formée comme une partie supérieure du semi-conducteur en forme d'île ;
dans lequel la deuxième couche semi-conductrice (251) a une première partie et une deuxième partie, dans lequel la grille (253) est formée de façon à entourer une périphérie extérieure de la première partie de la deuxième couche semi-conductrice (251) à travers le film d'isolation pour former, avec la première couche semi-conductrice (252), la première partie de la deuxième couche semi-conductrice (251) et la troisième couche semi-conductrice (254), un transistor de réinitialisation du dispositif d'imagerie, et la troisième couche semi-conductrice (254) est formée de façon à entourer une périphérie extérieure de la deuxième partie de la deuxième couche semi-conductrice (251) pour former, avec la deuxième couche semi-conductrice (251) et la quatrième couche semi-conductrice (250), un transistor d'amplification du dispositif d'imagerie.

2. Dispositif d'imagerie à semi-conducteurs selon la revendication 1, dans lequel la première partie de la deuxième couche semi-conductrice (251) est formée à une forme de pilier circulaire en coupe transversale.

3. Dispositif d'imagerie à semi-conducteurs selon la revendication 1, dans lequel la deuxième partie de la deuxième couche semi-conductrice (251) est formée à une forme de pilier circulaire en coupe transversale.

4. Matrice de dispositifs d'imagerie à semi-conducteurs comprenant une pluralité des dispositifs d'imagerie à semi-conducteurs selon la revendication 1, qui sont agencés sur le substrat en une matrice de n rangées par m colonnes, dans laquelle chacun de n et m est un entier de 1 ou plus.

5. Procédé de pilotage du dispositif d'imagerie à semi-conducteurs selon la revendication 1, comprenant les étapes d'application d'une première tension de pilotage à la ligne (255) de sélection de pixels, d'application d'une deuxième tension de pilotage à la ligne (256) de signaux et d'application d'une troisième tension de pilotage à la grille (253), pour réinitialiser la section (254) de stockage de charge.

6. Procédé selon la revendication 5, qui comprend en outre l'étape de réception d'une lumière, tout en appliquant la première tension de pilotage à celles respectives parmi la ligne (255) de sélection de pixels, la grille (253) et la ligne (256) de signaux, pour changer une quantité de charges électriques stockées dans la section (254) de stockage de charge.

7. Procédé selon la revendication 6, qui comprend en outre les étapes de :
application de la deuxième tension de pilotage à la ligne (255) de sélection de pixels, application de la première tension de pilotage à la grille (253) et application de la première tension de pilotage à la ligne (256) de signaux, pour produire un flux de courant de lecture tout en amplifiant les charges électriques stockées dans la section (254) de stockage de charge et de façon à exécuter une opération de lecture.

8. Procédé selon la revendication 7, dans lequel :
la première tension de pilotage est fixée à zéro V ;
la deuxième tension de pilotage est fixée à 1 V ; et
la troisième tension de pilotage est fixée à 1,5 V.
